# EUROPEAN PATENT SPECIFICATION

(11) **EP 4 033 263 B1**
(45) Date of publication and mention of the grant of the patent: **15.03.2023**
(21) Application number: 21190878.5
(22) Date of filing: 11.08.2021
(51) Int. Cl.: G01R 31/327

(54) **METHOD FOR TESTING THE RELAY FAILURE OF A THREE-PHASE GRID-CONNECTED INVERTER**
VERFAHREN ZUM PRÜFEN DES RELAISAUSFALLS EINES DREIPHASIGEN NETZGEKOPPELTEN WECHSELRICHTERS
PROCÉDÉ PERMETTANT DE TESTER LA DÉFAILLANCE D'UN RELAIS D'ONDULEUR TRIPHASÉ RACCORDÉ AU RÉSEAU

(30) Priority: 21.01.2021 CN 202110080884
(43) Date of publication of application: 27.07.2022
(73) Proprietor: Solar Power Network Technology (Zhejiang) Co., Ltd., 311500 Hangzhou Zhejiang (CN)
(72) Inventor: Xiao, Yongli, Hangzhou 311500 (CN); Li, Xinfu, Hangzhou 311500 (CN); Zhu, Dongmin, Hangzhou 311500 (CN)
(74) Representative: karo IP

(56) References cited:
- EP-A1- 3 176 802
- CN-B- 107 957 546
- CN-B- 108 761 319

## Description

### TECHNICAL FIELD

The present invention belongs to the field of three-phase grid-connected inverters, in particular to a method for testing the relay failure of a three-phase grid-connected inverter.

### BACKGROUND

For the purpose of safety, the grid-connected inverter should be equipped with relays for electrical isolation between output terminals and grid terminals. For a three-phase grid-connected inverter, relays must be installed between the phases A, B and C of the grid and the output terminals of the inverter. When the inverter is inoperative, the relays must be reliably disconnected to ensure that there is no electrical connection between the inverter and the power grid. If relay sticking occurs, it will bring a great potential safety hazard. Therefore, before the inverter is started for operation, the relays must be tested for sticking to ensure that the relays are in normal operating conditions. In addition, if the inverter can accurately identify and locate the faulty relay when the relays cannot pick up normally, it can also greatly save the repair time and cost of the inverter.

If each relay driving signal is independent, it is very easy to identify the relay sticking or pickup failure, and failing relay may be identified just by the following steps: putting the relay in an off or pickup state, keeping other relays in a pickup or off state and testing whether voltages at both ends of the relay are equal. However, the relays on three-phase lines A, B and C often use the same driving signal in order to reduce the design cost of the inverter, which brings a trouble to relay test. For the conventional three-phase grid-connected inverter, the inverter voltages tested include inverter output terminal voltages and grid phase voltages. The inverter output terminal voltages tested cover the voltages of the inverter output terminals of the three phases Ai, Bi and Ci to the neutral point Ni of DC BUS, and the grid phase voltages tested cover the voltages of the three phases A, B and C of the grid to the zero line N. Under normal conditions, if the Ni potential is equal to the zero line N potential, relay sticking or pickup failure may be judged by testing whether the inverter output terminal voltage is equal to the grid phase voltage with the relay in an off or pickup state. However, the Ni point potential is floating in the design of the inverter, which may be either equal to or different from the zero line N potential. In this way, it is possible that relay sticking is reported incorrectly as the tested inverter output terminal voltage is likely to be equal to the grid phase voltage due to floating potential at Ni point with the relay in an off state. On the contrary, an alarm may also be incorrectly given by erroneously identifying that the relay does not pick up as the Ni point potential is not equal to the zero line N potential with the relay in a pickup state, so that the inverter cannot operate and generate electricity normally. The European patent EP 3 176 802 A1 discloses a system and a method for verifying circuitbreaker unit of three-phase DC/AC converter, which has voltage detectors including detector part associated with phases for measuring voltages between middle points and neutral of grid. The method applies an AC voltage to the circuit breaker, opens/closes the circuit breaker and checks the state of the circuit breaker based on the measured voltages on the phases. It further uses an additional voltage detector for measuring the reference voltage between the neutral of the power grid and a reference point of the DC side of the three-phase DC/AC converter.

The Chinese patent CN108761319B discloses "a method, device and system for testing the relay failure of a photovoltaic grid-connected inverter", which is used for the situation that relay test fails for three-phase grid-connected equipment, and additional tests are required for other point voltages to make the system more complex; it is also true that only simultaneous sticking of a group of relays with the same driving signal can be identified, not suitable for a single relay.

The Chinese patent CN107957546B discloses "a test method and equipment for inverter grid-connected AC relays", which is also used for the relay failure test of a three-phase grid-connected inverter, but solves the technical problem of relay test failure in the case of grid short to ground, which is totally different from that to be solved by the present invention.

### SUMMARY

In order to solve the above-mentioned technical problems in the prior art, the present invention provides a method for testing the relay failure of a three-phase grid-connected inverter, and a group of relays are arranged for isolation at the output terminals A, B, C and the grid terminal of the three-phase grid-connected inverter, comprising the following steps:
Step 1. Sending the same disconnection driving signal to all the relays S1, S2 and S3 on the three phases A, B and C of the power grid;
Step 2. Sending continuity signals to power transistors Q1, Q3 and Q5 of the inverter, and keeping the power transistors Q2, Q4 and Q6 in an off state; wherein, one end of the power transistors Q1, Q3 and Q5 is connected with the positive terminal of the PV panel, and one end of the power transistors Q2, Q4 and Q6 is connected with the negative terminal of the PV panel;
Step 3. Measuring the average value of voltages Via, Vib and Vic at the output terminals of the three-phase grid-connected inverter within a mains period respectively;
Step 4. Judging whether the average value of the voltages Via, Vib and Vic at each output terminal of the inverter is greater than the set threshold Vt within a mains period;
if it is greater than the set threshold Vt, it is judged that the relay disconnects normally;
if the average value at a certain phase is smaller than the set threshold Vt, it is judged that the relay on that phase sticks.

Further, it also comprises the following steps:
Step 5. Sending the same pickup driving signal to all the relays S1, S2 and S3 on the three phases A, B and C of the grid, and testing the average value of the voltages Via, Vib and Vic at the output terminals of the inverter within a mains period respectively;
if it is smaller than the set threshold Vt, it is judged that the relay picks up normally;
if a certain phase is greater than the set threshold Vt, it is judged that the relay on that phase cannot pick up normally.

Further, Step 2 can be replaced by: sending continuity signals to power transistors Q2, Q4 and Q6 of the inverter, and keeping the power transistors Q1, Q3 and Q5 in an off state.

Further, an anti-counter-current diode or a non-isolated DC/DC circuit can be arranged between the internal inverter circuit of the three-phase grid-connected inverter and the PV panel.

Further, in Step 3, the average value of voltages Via, Vib and Vic within a mains period is calculated for many times before averaging.

Further, the set threshold Vt is 3V.

Further, an alarm is generated when relay sticking or pickup failure is identified.

Further, the group of relays are replaced by two or more groups of relays for in-series isolation, and when one group of relays are tested, other groups of relays are in the pickup state.

Further, all groups of relays are tested in sequence.

Further, the test method is applied to three-phase grid-connected inverters without zero line connection.

### Beneficial effects:

The present invention proposes to test the voltages of the three-phase output terminals Ai, Bi and Ci of the inverter to a zero line N in the situation that the relays on each phase of the three-phase grid-connected inverter are driven by the same driving signal. With the help of the pickup action of the switch tubes Q1, Q3 and Q5 (or Q2, Q4 and Q6) of the inverter as well as test on the actually existing voltage to ground of a PV panel, it is possible to correctly test whether sticking or pickup failure occurs to the relay on a certain phase, without test error, and 100% accurate test is achievable without erroneous test.

The present invention can indirectly work out the output terminal line voltage of the inverter through the voltages of the output terminals Ai, Bi and Ci to the zero line N so as to test relay failure of the three-phase grid-connected inverter, without affecting other functions of the grid-connected inverter or increasing additional costs.

### BRIEF DESCRIPTION OF THE DRAWINGS

FIG. 1 is a relay failure test diagram of the three-phase grid-connected inverter of the present invention;
FIG. 2 is another relay failure test diagram of the three-phase grid-connected inverter of the present invention with a non-isolated DC/DC circuit.

### DETAILED DESCRIPTION OF THE PREFERRED EMBODIMENTS

The present invention will be further explained below in combination with the drawings.

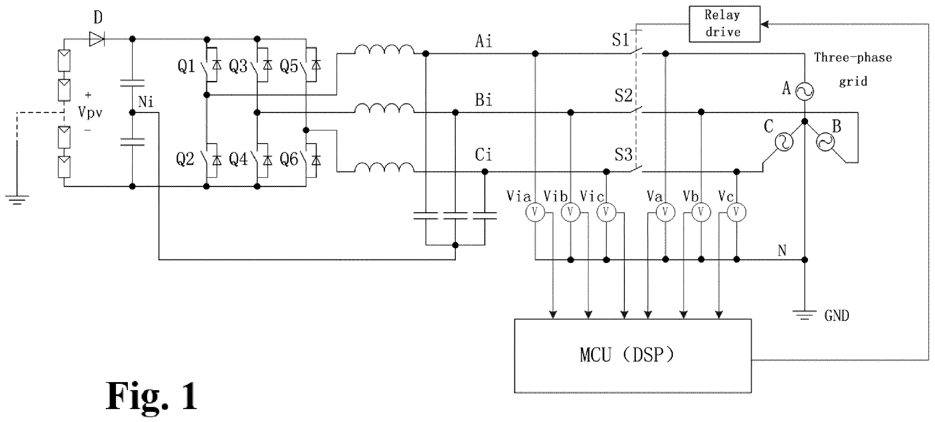

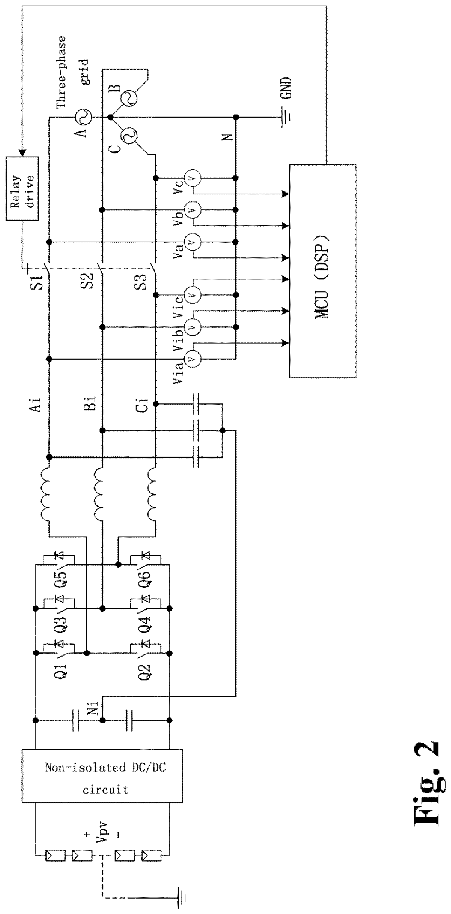

As shown in FIGS. 1 and 2, the method for testing the relay failure of a three-phase grid-connected inverter of the present invention alters testing the voltages of three-phase output terminals Ai, Bi and Ci of the inverter to the neutral point Ni of DC BUS in the prior art into testing the voltages of three-phase output terminals Ai, Bi and Ci to the zero line N. With the help of the on-off characteristic of the power transistors of the inverter, when the inverter output relay is off, the power transistors Q1, Q3 and Q5 of the circuit of the three-phase grid-connected inverter are firstly conducted, while Q2, Q4 and Q6 are simultaneously disconnected. An anti-counter-current diode D or a non-isolated DC/DC circuit may be arranged between the internal inverter circuit of the three-phase grid-connected inverter and the PV panel, so that the three-phase output terminals Ai, Bi and Ci of the inverter are directly communicated with the positive terminal of the PV panel. The voltages Via, Vib and Vic to ground of the three-phase output terminals Ai, Bi and Ci of the inverter are equal to the voltage to ground of the positive terminal of the PV panel, which is a DC voltage, equal to half of the voltage of the PV panel, while the grid phase voltages Va, Vb and Vc are AC voltages, the average value of which within a mains period is 0. If the average value of voltages Via, Vib and Vic within a mains period is not 0, it is judged that no sticking occurs to the relay; if the average value of voltages Via, Vib or Vic within a mains period is 0, it is judged that sticking occurs to the relay on a certain phase with the average value of 0.

If a pickup command is sent to the relays, Via, Vib and Vic are exactly equal to Va, Vb and Vc after the relays pick up under normal conditions, which are equal to the grid voltages. At this time, if the average value of voltages Via, Vib and Vic is 0 within a mains period, it is judged that the relay picks up normally; if the average value of voltages Via, Vib and Vic is not 0 within a mains period, it is judged that the relay on this phase does not pick up normally.

Alternatively, if the power transistors Q2, Q4 and Q6 are connected and the power transistors Q1, Q3 and Q5 are disconnected prior to test, the three-phase output terminals Ai, Bi and Ci of the inverter are directly connected with the negative terminal of the PV panel, the voltage to ground of the negative terminal of the PV panel is also half of PV voltage, which is a negative, but the test method is the same as that described above.

The specific test steps of the method for testing the relay failure of a three-phase grid-connected inverter of the present invention are as follows:
Step 1. Judging whether the power grid is normal; if yes, go to Step 2 for relay test; otherwise, report an alarm of power grid abnormality;
Step 2. Sending the same disconnection driving signal to all the relays S1, S2 and S3 on three phases A, B and C of the power grid (all the relays S1, S2 and S3 are disconnected under normal conditions);
Step 3. Sending continuity signals to the power transistors Q1, Q3 and Q5 of the inverter, and ensuring that power transistors Q2, Q4 and Q6 are always in an off state;
Step 4. Calculating the average value of the voltages Via, Vib and Vic at the output terminals of the three-phase grid-connected inverter within a mains period (the average value of voltages Via, Vib and Vic within a mains period is usually calculated for many times before averaging for the purpose of test reliability);
Step 5. Judging whether the average value of the voltages Via, Vib and Vic at each output terminal of the inverter is greater than the set threshold Vt within a mains period (the threshold value is zero in theory, but there will be errors in voltage test in practical applications, and the threshold value may be taken as 3V); if it is greater than the threshold value, the relay disconnects normally, skip to Step 5; if the average value of voltages Via, Vib and Vic is smaller than the threshold value within a mains period, it can be judged that sticking occurs to the relay on a certain phase, an alarm is given, and the test is terminated;
Step 6. Sending the same closing driving signal to all the relays S1, S2 and S3 on the three phases A, B and C again, and testing the average value of voltages Via, Vib and Vic at the output terminals of the inverter within a mains period. If all the voltages are smaller than the set threshold Vt, it is judged that the relay picks up normally; otherwise, if the voltage of a certain phase is greater than the set threshold Vt, it is judged that the relay on that phase cannot pick up normally, then an alarm is given, and the test ends.

The control command sending of all the above signals as well as voltage data collection and calculation are realized by related circuits inside the existing inverter and the MCU (DSP) digital controller.

The present invention is characterized in that the design cost of the inverter is not additionally increased, but testing the voltages of three-phase output terminals Ai, Bi and Ci of the inverter to the neutral point Ni of DC BUS is just altered into testing the voltages of three-phase output terminals Ai, Bi and Ci to the zero line N. This alteration does not affect other functions of the inverter, but can correctly identify relay sticking and pickup failure with the help of pickup action of the power transistors Q1, Q3 and Q5 (or Q2, Q4 and Q6) of the inverter as well as test on the actually existing voltage to ground of the PV panel.

The test method of the present invention applies not only to a group of relays for isolation at the output terminals Ai, Bi, Ci and the grid terminal of the three-phase inverter, but also to two or more groups of relays for in-series isolation. To test a group of relays, just make the other groups of relays in a pickup state, so that all the relays sharing the same driving signal can be tested by performing in sequence.

The test method of the present invention applies not only to the three-phase grid-connected inverter with zero line connected, but also to the three-phase grid-connected inverter with no zero line connected. For the application scenario of the grid-connected inverter with no zero line connected, the effective test of the present invention will not be affected as long as the potential to ground of zero line N of the actual power grid is 0 in theory (it is also true for the actual situation).

The present invention applies not only to the two-level inverter topology shown in FIG. 1 and FIG. 2, but also to three-level inverter topology or above.

## Claims

1. A method for testing the relay failure of a three-phase grid-connected inverter, a group of relays are arranged for isolation at the output terminals (A, B, C) and the grid terminal of the three-phase grid-connected inverter respectively the method comprising the following steps:
Step 1. Sending the same disconnection driving signal to all the relays (S1, S2 and S3) on the three phases (A, B, C) of the power grid;
Step 2. Sending continuity signals to a first group of power transistors (Q1, Q3, Q5) of the inverter, and keeping a second group of power transistors (Q2, Q4, Q6) in an off state, or sending continuity signals to the second group of power transistors (Q2, Q4, Q6) of the inverter, and keeping the first group of power transistors (Q1, Q3, Q5) in an off state; wherein, one end of the first group of power transistors (Q1, Q3, Q5) is connected with the positive terminal of the photovoltaic (PV) panel, and one end of the second group of power transistors (Q2, Q4, Q6) is connected with the negative terminal of the photovoltaic (PV) panel;
Step 3. Measuring the average value of voltages (Via, Vib, Vic) of the three-phase output terminals (Ai, Bi, Ci) of the three-phase grid-connected inverter to a zero line (N) within a mains period respectively;
Step 4. Judging whether the average value of the voltages (Via, Vib, Vic) at each output terminal of the inverter is greater than the set threshold Vt within a mains period;
if it is greater than the set threshold Vt, it is judged that the relay disconnects normally;
if the average value at a certain phase is smaller than the set threshold Vt, it is judged that the relay on that phase sticks.

2. The method for testing the relay failure of a three-phase grid-connected inverter according to Claim 1, **characterized in that** it also comprises the following steps:
Step 5: Sending the same pickup driving signal to all the relays (S1, S2, S3) on the three phases (A, B, C) of the grid, and testing the average value of the voltages (Via, Vib, Vic) at the output terminals of the inverter within a mains period respectively;
if it is smaller than the set threshold Vt, it is judged that the relay picks up normally;
if a certain phase is greater than the set threshold Vt, it is judged that the relay on that phase cannot pick up normally.

3. The method for testing the relay failure of a three-phase grid-connected inverter according to any of Claims 1-2, **characterized in that**:
an anti-counter-current diode or a non-isolated DC/DC circuit is arranged between the internal inverter circuit of the three-phase grid-connected inverter and the photovoltaic, PV, panel.

4. The method for testing the relay failure of a three-phase grid-connected inverter according to any of Claims 1-3, **characterized in that**:
in Step 3, the average value of voltages (Via, Vib, Vic) at the output terminal of the inverter within a mains period is calculated for many times before averaging.

5. The method for testing the relay failure of a three-phase grid-connected inverter according to any of Claims 1-4, **characterized in that**:
the set threshold Vt is 3V.

6. The method for testing the relay failure of a three-phase grid-connected inverter according to Claim 2, **characterized in that**:
an alarm is generated when relay sticking or pickup failure is identified.

7. The method for testing the relay failure of a three-phase grid-connected inverter according to any of Claims 1-6, **characterized in that**:
the group of relays are replaced by two or more groups of relays for in-series isolation, and when one group of relays are tested, other groups of relays are in the pickup state.

8. The method for testing the relay failure of a three-phase grid-connected inverter according to Claim 7, **characterized in that**: all groups of relays are tested in sequence.

9. The method for testing the relay failure of a three-phase grid-connected inverter according to any of Claims 1-8, **characterized in that**:
the test method is applied to three-phase grid-connected inverters with no zero line connected.

## Patentansprüche

1. Ein Verfahren zur Überprüfung eines Relaisausfalls eines dreiphasigen netzgekoppelten Wechselrichters, wobei eine Gruppe von Relais zur Trennung an den Ausgangsanschlüssen (A, B, C) und dem jeweiligen Netzanschluss des dreiphasigen netzgekoppelten Wechselrichters angeordnet ist, wobei das Verfahren die folgenden Schritte umfasst:
Schritt 1. Senden desselben Abschaltsteuersignals an alle Relais (S1, S2 und S3) an den drei Phasen (A, B, C) des Stromnetzes;
Schritt 2. Durchlasssignale an eine erste Gruppe von Leistungstransistoren (Q1, Q3, Q5) des Wechselrichters senden und eine zweite Gruppe von Leistungstransistoren (Q2, Q4, Q6) im Aus-Zustand halten, oder Durchlasssignale an die zweite Gruppe von Leistungstransistoren (Q2, Q4, Q6) des Wechselrichters senden und die erste Gruppe von Leistungstransistoren (Q1, Q3, Q5) im Aus-Zustand halten; wobei ein Ende der ersten Gruppe von Leistungstransistoren (Q1, Q3, Q5) mit dem positiven Anschluss des photovoltaischen (PV) Panels verbunden ist, und ein Ende der zweiten Gruppe von Leistungstransistoren (Q2, Q4, Q6) mit dem negativen Anschluss des photovoltaischen (PV) Panels verbunden ist;
Schritt 3. Messen des Mittelwerts der Spannungen (Via, Vib, Vic) der dreiphasigen Ausgangsanschlüsse (Ai, Bi, Ci) des dreiphasigen netzgekoppelten Wechselrichters gegen eine Null-Leitung (N) jeweils innerhalb einer Netzperiode;
Schritt 4. Beurteilen, ob der Mittelwert der Spannungen (Via, Vib, Vic) an jedem Ausgangsanschluss des Wechselrichters innerhalb einer Netzperiode größer als der eingestellte Schwellenwert Vt ist;
ist er größer als der eingestellte Schwellenwert Vt, wird gefolgert, dass das Relais normal abfällt;
wenn der Mittelwert einer bestimmten Phase kleiner als der eingestellte Schwellenwert Vt ist, wird gefolgert, dass das Relais dieser Phase klebt.

2. Verfahren zur Überprüfung eines Relaisausfalls eines dreiphasigen netzgekoppelten Wechselrichters nach Anspruch 1, **dadurch gekennzeichnet, dass** es außerdem die folgenden Schritte umfasst:
Schritt 5: Senden desselben Ansteuersignals an alle Relais (S1, S2, S3) an den drei Phasen (A, B, C) des Netzes und Prüfung des Mittelwerts der Spannungen (Via, Vib, Vic) an den Ausgangsanschlüssen des Wechselrichters jeweils innerhalb einer Netzperiode;
ist er kleiner als der eingestellte Schwellenwert Vt, wird gefolgert, dass das Relais normal anzieht;
wenn eine bestimmte Phase größer als der eingestellte Schwellenwert Vt ist, wird gefolgert, dass das Relais auf dieser Phase nicht normal anziehen kann.

3. Verfahren zur Überprüfung eines Relaisausfalls eines dreiphasigen netzgekoppelten Wechselrichters nach einem der Ansprüche 1-2, **dadurch gekennzeichnet, dass**:
zwischen dem internen Wechselrichterschaltkreis des dreiphasigen netzgekoppelten Wechselrichters und dem photovoltaischen, PV, Panel eine Gegenstromsperrdiode oder eine nicht isolierte DC/DC-Schaltung angeordnet wird.

4. Verfahren zur Überprüfung eines Relaisausfalls eines dreiphasigen netzgekoppelten Wechselrichters nach einem der Ansprüche 1-3, **dadurch gekennzeichnet, dass**:
in Schritt 3 der Mittelwert der Spannungen (Via, Vib, Vic) am Ausgangsanschluss des Wechselrichters innerhalb einer Netzperiode vor der Mittelwertbildung viele Male berechnet wird.

5. Verfahren zur Überprüfung eines Relaisausfalls eines dreiphasigen netzgekoppelten Wechselrichters nach einem der Ansprüche 1-4, **dadurch gekennzeichnet, dass**:
der eingestellte Schwellenwert Vt 3V beträgt.

6. Verfahren zur Überprüfung eines Relaisausfalls eines dreiphasigen netzgekoppelten Wechselrichters nach Anspruch 2, **dadurch gekennzeichnet, dass**:
ein Alarm erzeugt wird, wenn ein Relaiskleben oder ein Anzugsfehler festgestellt wird.

7. Verfahren zur Überprüfung eines Relaisausfalls eines dreiphasigen netzgekoppelten Wechselrichters nach einem der Ansprüche 1-6, **dadurch gekennzeichnet, dass**:
die Relaisgruppe durch zwei oder mehr Gruppen von Relais für eine Trennung in Reihe ersetzt wird, und wenn eine Gruppe von Relais getestet wird, andere Gruppen von Relais sich in angezogenem Zustand befinden.

8. Verfahren zur Überprüfung eines Relaisausfalls eines dreiphasigen netzgekoppelten Wechselrichters nach Anspruch 7, **dadurch gekennzeichnet, dass**:
alle Relaisgruppen nacheinander geprüft werden.

9. Verfahren zur Überprüfung eines Relaisausfalls eines dreiphasigen netzgekoppelten Wechselrichters nach einem der Ansprüche 1-8, **dadurch gekennzeichnet, dass**:
das Prüfverfahren bei dreiphasigen netzgekoppelten Wechselrichtern ohne angeschlossene Null-Leitung angewendet wird.

## Revendications

1. Procédé de test de défaillance de relais d'un onduleur triphasé raccordé au réseau, un groupe de relais étant disposé en vue d'une isolation respectivement aux bornes de sortie (A, B, C) et à la borne de réseau de l'onduleur triphasé raccordé au réseau, le procédé comprenant les étapes suivantes :
Etape I. Envoi du même signal de commande de déconnexion à tous les relais (S1, S2 et S3) sur les trois phases (A, B, C) du réseau électrique ;
Etape 2. Envoi de signaux de continuité à un premier groupe de transistors de puissance (Q1, Q3, Q5) de l'onduleur, et maintien d'un second groupe de transistors de puissance (Q2, Q4, Q6) dans un état bloqué, ou envoi de signaux de continuité au second groupe de transistors (Q2, Q4, Q6) de l'onduleur, et maintien du premier groupe de transistors de puissance (Q1, Q3, Q5) dans un état bloqué ;
dans lequel une extrémité du premier groupe de transistors de puissance (Q1, Q3, Q5) est connectée à la borne positive du panneau photovoltaïque (PV) et une extrémité du second groupe de transistors de puissance (Q2, Q4, Q6) est connectée à la borne négative du panneau photovoltaïque (PV) ;
Etape 3. Mesure de la valeur moyenne de tensions (Via, Vib, Vic) des bornes de sortie triphasées (Ai, Bi, Ci) de l'onduleur triphasé raccordé au réseau par rapport à une ligne zéro (N) dans une période de secteur respectivement ;
Etape 4. Juger que la valeur moyenne des tensions (Via, Vib, Vic) à chaque borne de sortie de l'onduleur est supérieure ou non au seuil de consigne Vt dans une période de secteur ;
si elle est supérieure au seuil de consigne Vt, il est jugé que le relais se déconnecte normalement ;
si la valeur moyenne à une certaine phase est inférieure au seuil de consigne Vt, il est jugé que le relais reste collé sur cette phase.

2. Procédé de test de défaillance de relais d'un onduleur triphasé raccordé au réseau selon la revendication 1, **caractérisé en ce qu'**il comprend également les étapes suivantes :
Etape 5: Envoi du même signal de commande d'appel à tous les relais (S1, S2, S3) sur les trois phases (A, B, C) du réseau, et test de la valeur moyenne des tensions (Via, Vib, Vic) aux bornes de sortie de l'onduleur dans une période de secteur respectivement ;
si elle est inférieure au seuil de consigne Vt, il est jugé le relais vient normalement à l'appel ;
si une certaine phase est supérieure au seuil de consigne Vt, il est jugé que le relais sur cette phase ne peut pas venir normalement à l'appel.

3. Procédé de test de défaillance de relais d'un onduleur triphasé raccordé au réseau selon l'une quelconque des revendications 1-2, **caractérisé en ce que** :
une diode anti-contre-courant ou un circuit C.C/C.C. non isolé est disposé entre le circuit d'onduleur interne de l'onduleur triphasé raccordé au réseau et le panneau photovoltaïque (PV).

4. Procédé de test de défaillance de relais d'un onduleur triphasé raccordé au réseau selon l'une quelconque des revendications 1-3, **caractérisé en ce que** :
à l'étape 3, la valeur moyenne de tensions (Via, Vib, Vic) à la borne de sortie de l'onduleur durant une période de secteur est calculée de nombreuses fois avant le moyennage.

5. Procédé de test de défaillance de relais d'un onduleur triphasé raccordé au réseau selon l'une quelconque des revendications 1-4, **caractérisé en ce que** :
le seuil de consigne Vt est de 3 V.

6. Procédé de test de défaillance du relais d'un onduleur triphasé raccordé au réseau selon la revendication 2, **caractérisé en ce que** :
une alarme est générée à l'identification qu'un relais reste collé ou ne vient pas à l'appel.

7. Procédé de test de défaillance de relais d'un onduleur triphasé raccordé au réseau selon l'une quelconque des revendications 1-6, **caractérisé en ce que** :
le groupe de relais est remplacé par deux ou plusieurs groupes de relais pour un isolement en série, et lorsqu'un groupe de relais est testé, d'autres groupes de relais sont dans l'état d'appel.

8. Procédé de test de défaillance de relais d'un onduleur triphasé raccordé au réseau selon la revendication 7, **caractérisé en ce que** :
tous les groupes de relais sont testés en séquence.

9. Procédé de test de défaillance de relais d'un onduleur triphasé raccordé au réseau selon l'une quelconque des revendications 1-8, **caractérisé en ce que** :
le procédé de test est appliqué à des onduleurs triphasés raccordés au réseau sans ligne zéro connectée.
